Europäisches Patentamt

**European Patent Office**

Office européen des brevets

(19)

(11) Numéro de publication: **0 089 439**
**A2**

(12) # DEMANDE DE BREVET EUROPEEN

(21) Numéro de dépôt: **82402389.9**

(22) Date de dépôt: **28.12.82**

(51) Int. Cl.³: **H 05 K 3/32**
**G 02 F 1/13**

(30) Priorité: **24.03.82 FR 8204995**

(43) Date de publication de la demande:
**28.09.83 Bulletin 83/39**

(84) Etats contractants désignés:
**AT BE CH DE GB IT LI LU NL SE**

(71) Demandeur: **TESTUT-AEQUITAS**
**8, rue Popincourt**
**F-75011 Paris(FR)**

(72) Inventeur: **Quehen, Daniel**
**26 avenue Charles de Gaulle**
**F-91380 Chilly Mazarin(FR)**

(74) Mandataire: **Martin, Jean-Jacques et al,**
**Cabinet REGIMBEAU 26, Avenue Kléber**
**F-75116 Paris(FR)**

(54) **Dispositif support pour afficheurs à cristaux liquides.**

(57) La présente invention concerne un dispositif support pour afficheurs à cristaux liquides.

Le dispositif comprend un cadre rigide (10) qui supporte d'une part deux languettes (20) normales au plan moyen du cadre et munies en extrémité de reliefs constituant des portées d'appui dirigées vers le cadre, d'autre part quatre lamelles flexibles (41, 42) dont les extrémités (45, 46) sont destinées à venir en appui contre un afficheur à cristaux liquides. Les quatre points de contact élastiques définis sur l'afficheur par les extrémités des lamelles (41, 42), permettent d'assurer le maintien de l'afficheur et d'un circuit imprimé comportant des orifices dans lesquels les languettes (20) sont encliquetées et assurent l'interconnexion correcte de l'afficheur.

FIG.1

EP 0 089 439 A2

DISPOSITIF SUPPORT  POUR AFFICHEURS A CRISTAUX LIQUIDES.

La présente invention concerne un dispositif support pour afficheurs à cristaux liquides.

Quel que soit le mode de fonctionnement retenu, classiquement la cellule de base de cristal liquide comprend deux plaques de verre ayant chacune un revêtement conducteur, entre lesquels le cristal liquide est introduit.

Pour supporter convenablement les afficheurs à cristaux liquides ainsi formés de façon à assurer une bonne mise en place de l'afficheur et une interconnexion correcte de celui-ci, on prévoyait jusqu'ici une pièce formant capot sur laquelle les afficheurs à cristaux liquides étaient assemblés à l'aide d'une pluralité de dispositifs de fixation du type vis-écrou. Plus précisément, il était universellement reconnu jusqu'ici qu'il était indispensable de porter l'afficheur en contact avec le capot, sur toute sa longueur, pour assurer une immobilisation et un support corrects de l'afficheur.

La Demanderesse a constaté que le mode d'assemblage précédemment utilisé présentait différents inconvénients.

En particulier, la sollicitation des afficheurs, engendrée par lesdites vis de fixation, entraîne une flexion axiale de ceux-ci particulièrement néfaste pour leur fonctionnement.

Mais également les dispositifs de fixation du type vis-écrou requièrent un espace important qui limite très notablement la place et la liberté de positionnement des pistes conductrices assurant les connexions avec l'afficheur, pistes qui sont prévues de façon classique, sur un circuit imprimé.

Enfin, le temps de mise en place imposé par ces dispositifs reste long.

Les dispositifs supports pour afficheurs à cristaux liquides, antérieurement existants, ne donnent donc pas pleinement satisfaction.

Pourtant les applications des afficheurs à cristaux liquides se sont multipliées considérablement au cours des dernières années.

Un tel développement, qui s'effectue aux dépens notamment des afficheurs à diodes électroluminescentes, pour lesquelles les afficheurs à cristaux liquides sont devenus de sérieux concurrents, est dû essentiellement au fait que ces derniers nécessitent de faibles niveaux de tension et de courant et sont commandables par circuits intégrés dits CMOS (transistors Complémentaires du type Semi-conducteur-Métal-Oxyde). Pour ces raisons, les afficheurs à cristaux liquides permettent d'augmenter très sensiblement la durée de vie des piles d'alimentation et autorisent un affichage permanent. Ces afficheurs à cristaux liquides sont ainsi particulièrement intérressants dans le cas d'instruments de mesure portables.

La présente invention vient maintenant proposer un nouveau mode de réalisation des dispositifs-support pour afficheurs à cristaux liquides, qui est à la fois robuste, de réalisation simple et économique, qui permet une installation rapide, et qui supporte convenablement les afficheurs pour assurer un contact électrique fiable, sans pour autant engendrer une sollicitation notable sur les afficheurs.

Le dispositif support pour afficheurs à cristaux liquides conforme à la présente invention se compose d'un ensemble définissant au moins deux languettes parallèles légèrement flexibles, qui sont munies au voisinage de l'une de leurs extrémités de reliefs qui constituent des portées d'appui dirigées vers l'autre extrémité, lesdits reliefs étant destinés à être encliqueter dans des orifices correspondants prévus dans la plaque de circuit imprimé ou organe analogue pour venir en appui sur celui-ci, et par le fait qu'il est prévu, au voisinage de l'autre extrémité des languettes, des lamelles flexibles dont les extrémités libres, destinées à constituer des points de contact élastique sur un afficheur posé sur le circuit imprimé, forment saillie en direction des portées d'appui prévues sur lesdites languettes, de telle sorte qu'un afficheur puisse être immobilisé entre le circuit imprimé et lesdites lamelles.

Selon un mode de réalisation préférentiel, le dispositif support pour afficheurs à cristaux liquides conforme à la présente invention comprend un cadre rigide rectangulaire composé d'un assemblage de deux parois longitudinales et deux parois transversales ; le cadre supporte à ses extrémités, au moins deux languettes parallèles légèrement flexibles, qui s'étendent perpendiculairement au plan moyen du cadre et d'un même côté de celui-ci ; lesdites languettes sont munies, au voisinage de leur extrémité libre de reliefs qui constituent des portées d'appui dirigées vers le cadre, lesdites languettes étant destinées à venir s'encliqueter dans des orifices correspondants prévus dans une plaque de circuit imprimé ou organe analogue portant les pistes conductrices amenées en contact avec les afficheurs ; d'autre part, il est prévu des lamelles flexibles, au niveau de chaque extrémité du cadre et dans le contour de celui-ci, les extrémités libres des lamelles formant saillie en direction des portées d'appui, de telle sorte que lorsqu'un afficheur à cristaux liquides est logé dans le cadre, et que les reliefs des languettes sont encliquetés dans les trous correspondants du circuit imprimé, les points de contact élastiques définis sur l'afficheur par lesdites saillies maintiennent le circuit imprimé contre les portées d'appui et assurent l'immobilisation et l'interconnection correctes de l'afficheur.

De préférence il est ainsi prévu quatre lamelles flexibles disposées deux à deux à chaque extrémité du cadre, lesdites lamelles ayant des extensions sensiblement parallèles au plan moyen du cadre.

Allant à l'encontre des idées préconçues, la Demanderesse a ainsi constaté qu'un dispositif support pour afficheurs à cristaux liquides, utilisant la rigidité du verre de l'afficheur, permettait d'immobiliser correctement celui-ci et donnait ainsi pleinement satisfaction.

Le dispositif conforme à la présente invention présente en particulier l'avantage de comporter des moyens de fixation peu volumineux, ce qui donne un degré de liberté important dans le positionnement des pistes conductrices sur le circuit imprimé, d'autre part le dispositif conforme à la présente invention permet un assemblage très rapide.

Selon une caractéristique préférentielle de la présente invention, le cadre rigide du dispositif support pour afficheurs à cristaux liquides comporte en outre un ergot de positionnement, normal au plan moyen du cadre et disposé du même côté de celui-ci que lesdites languettes.

Selon une caractéristique de la présente invention, les lamelles flexibles prévues sur le dispositif support pour afficheurs à cristaux liquides sont reliées au cadre, au voisinage des parois transversales du cadre, à mi-longueur de celles-ci, et s'étendent latéralement en direction des parois longitudinales tout en étant légèrement inclinées en direction des portées d'appui définies sur les languettes.

De préférence, le dispositif support pour afficheurs à cristaux liquides, conforme à la présente invention est réalisé par moulage en une seule pièce d'un matériau polymère.

Selon un autre mode de réalisation, ledit ensemble se compose de deux pièces séparées, disposées respectivement à chacune des extrémités de l'afficheur, chacune desdites pièces comportant, d'une part, au moins une languette, d'autre part, au moins une lamelle. Dans un tel cas, le dispositif est de préférence réalisé par moulage de deux pièces en matériau polymère.

D'autres caractéristiques et avantages de la présente invention apparaîtront à la lecture de la description détaillée qui va suivre, et en regard des dessins annexés donnés à titre d'exemple non limitatif et sur lesquels :

- la figure 1 représente une vue partielle en perspective d'un dispositif support pour afficheurs à cristaux liquides conforme à la présente invention,

- la figure 2 représente une vue de dessus d'un dispositif support pour afficheurs à cristaux liquides conforme à la présente invention, placé sur une plaque de circuit imprimé schématiquement représentée,

- la figure 3 représente une vue latérale d'un dispositif support pour afficheurs à cristaux liquides disposé sur un circuit imprimé, la portion droite extrême dudit support étant représentée en coupe longitudinale,

- la figure 4 représente une vue de dessus d'un circuit imprimé susceptible d'être utilisé avec un dispositif support pour afficheurs à cristaux liquides conforme à la présente invention.

- la figure 5 représente une vue en coupe latérale d'une variante de réalisation du dispositif support pour afficheurs à cristaux liquides, conforme à la présente invention.

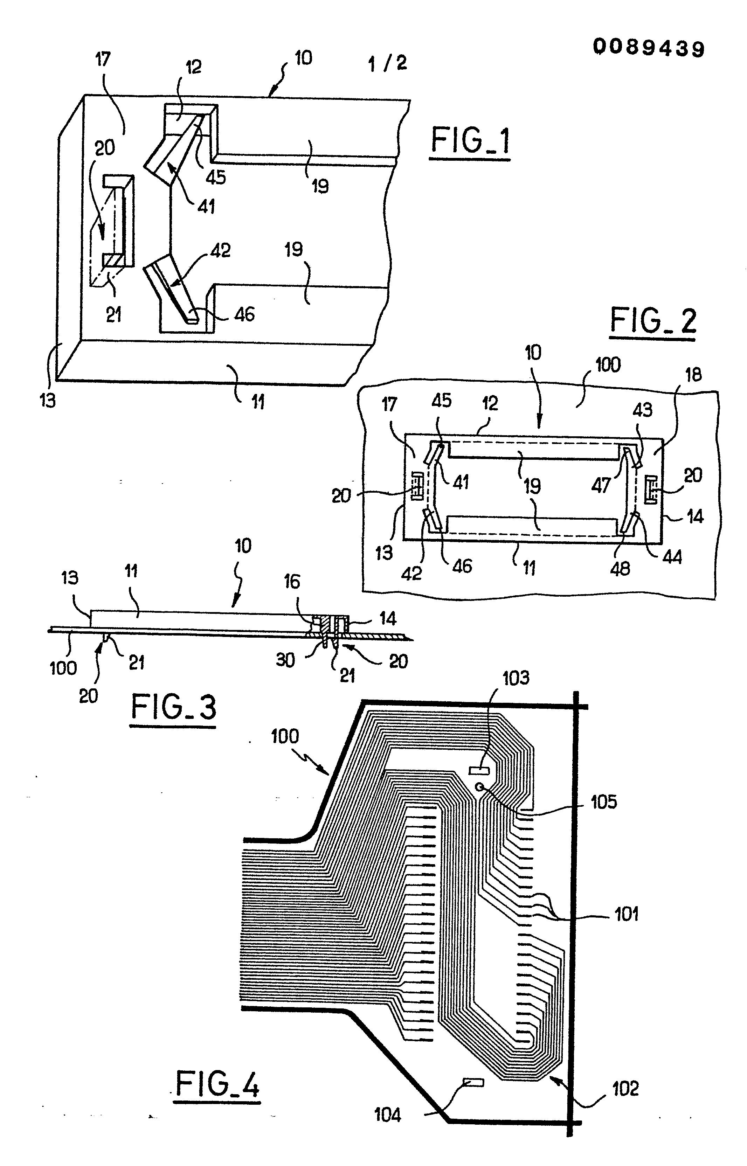

Comme cela apparaît sur les figures 1 à 3, le dispositif support pour afficheurs à cristaux liquides conforme à la présente invention comprend un cadre rigide rectangulaire qui porte la référence générale 10. Le cadre rigide 10 est composé d'un assemblage de deux parois longitudinales 11 et 12 et deux parois transversales extrêmes 13 et 14. L'épaisseur de chaque paroi est faible. La largeur des parois correspond à l'épaisseur du cadre. Cette dernière est faible par rapport à la longueur des parois longitudinales et transversales.

Les parois transversales 13 et 14 supportent chacune une languette 20 de section droite sensiblement rectangulaire ,légèrement flexible, qui s'étend perpendiculairement au plan moyen du cadre, c'est-à-dire un plan parallèle à la direction générale de chacune des parois. Les deux languettes 20 sont parallèles entre elles et situées d'un même côté du cadre. De préférence, les languettes sont légèrement biseautées au niveau de leur extrémité libre pour faciliter l'insertion dans le circuit imprimé.

Plus précisément, le cadre rigide comporte deux cloisons-renfort intermédiaires, de forme et dimensions sensiblement identiques aux parois transversales, telles que la cloison-renfort intermédiaire référencée 16 sur la figure 3. Ces cloisons-renfort intermédiaires (16) sont disposées perpendiculairement aux parois longitudinales 11 et 12, et relient celles-ci à faibles distances des parois transversales extrêmes précitées 13 et 14. D'autre part, comme cela apparaît sur les figures 1 et 2, le cadre rigide 10 comporte sur l'une de ses faces, deux plaques 17 et 18 ajourées (comme représenté figures 1 et 2), parallèles au plan moyen du cadre et reliant les parois transversales extrêmes 13 et 14 aux cloisons-renfort intermédiaires (16) qui leur sont respectivement associées.

Les languettes 20 précitées sont ainsi reliées aux parois ajourées 17 et 18, et s'étendent entre les parois transversales et les cloisons-renfort intermédiaires à l'opposé des parois ajourées jusqu'à faire saillie à l'extérieur de l'enveloppe du cadre rigide 10. En outre, les languettes 20 sont munies au voisinage de leur extrémité libre, de reliefs 21 qui constituent des portées d'appui dirigées vers le cadre ou plus précisément vers les parois ajourées 17 et 18. Les languettes 20 ainsi munies de reliefs 21 sont destinées à venir s'encliqueter dans des orifices (103) correspondants prévus dans une plaque de circuit imprimé (100) comme cela sera expliqué plus en détails dans la suite de la présente description.

D'autre part, le cadre rigide 10 supporte quatre lamelles flexibles 41, 42, 43 et 44. Les lamelles sont disposées respectivement deux à deux au niveau de chaque extrémité du cadre, et s'étendent sensiblement parallèles au plan moyen du cadre.

Plus précisément, comme cela est représenté sur les figures 1 et 2, les lamelles flexibles sont reliées aux parois ajourées 17 et 18, au niveau des cloisons-renfort intermédiaires (16) précitées. De plus, les extrémités libres 45, 46, 47 et 48 des lamelles 41 à 44, font saillie en direction des portées d'appui précitées prévues sur les languettes 20, de telle sorte que lorsqu'un afficheur à cristaux liquides est logé dans le cadre 10, à l'intérieur du périmètre défini par les deux parois longitudinales 11 et 12 et les deux cloisons-renfort intermédiaires (16),lesdites lamelles 41 à 44 définissent quatre points de contact sur les afficheurs.

Pour ce faire, on peut prévoir que les lamelles 41 à 44 comportent au niveau de leurs extrémités libres 45 à 48, des protubérances dirigées vers lesdites portées d'appui. Toutefois, selon cette disposition, lorsque l'afficheur introduit dans le cadre sollicite lesdites lamelles, il peut se faire que celles-ci fassent légèrement saillie au-dessus des parois 17 et 18 précitées.

Pour remédier à cet inconvénient il est préférable de prévoir que lesdites lamelles 41 à 44, comme cela est représenté en particulier sur la figure 1,sont reliées à la paroi ajourée, à mi-longueur de celle-ci et s'étendent sensiblement latéralement en direction des parois longitudinales, tout en étant légèrement inclinées en direction des portées d'appui définies sur les languettes. Ainsi lesdites lamelles 41 à 44 peuvent être légèrement déformées par un afficheur à cristaux liquides introduit dans le cadre 10, sans pour autant dépasser de l'enveloppe définie par celles-ci.

Bien entendu cette dernière disposition peut également être combinée avec l'utilisation de protubérances tel que précédemment indiqué.

Comme cela apparaît sur la figure 3, il est de préférence prévu en outre, sur le cadre rigide 10 un ergot de positionnement 30, décentré, normal au plan moyen du cadre 10 et disposé du même côté de celui-ci que lesdites languettes 20. Selon le mode de réalisation représenté sur la figure 3, l'ergot de positionnement 30 prolonge vers le bas l'une des cloisons-renfort intermédiaires (16), à mi-longueur de celle-ci.

Pour parfaire la finition et la présentation du dispositif, il est en outre possible de prévoir sur les parois longitudinales 11 et 12, des prolongements 19 normaux à celles-ci, et situés dans le plan des parois ajourées 17 et 18 précitées. Toutefois ces prolongements 19 n'interviennent pas dans la fixation des afficheurs. Leurs dimensions seront donc déterminées en fonction de l'effet esthétique recherché.

Comme cela apparaît sur la figure 4 qui représente un circuit imprimé comportant des pistes conductrices, susceptible d'être appliqué contre un afficheur à cristaux liquides logé dans un support conforme à la présente invention, la place requise pour les moyens de fixation est particulièrement limitée. En effet, comme cela apparaît sur cette figure 4, il suffit de prévoir deux trous rectangulaires référencés 103 et 104, destinés à recevoir les languettes 20 et leur relief 21 et un trou circulaire 105 destiné à recevoir l'ergot de positionnement 30. La totalité de la surface restante du circuit imprimé 100 peut être utilisée en toute liberté pour le positionnement des plots 101 destinés à venir en contact avec les bornes des afficheurs à cristaux liquides ainsi que les pistes 102 reliant lesdits plots 101 à tous types de connecteur classique.

Dans la plupart des cas, les afficheurs à cristaux liquides et les plaques de circuit imprimé ne présentent pas une planéité parfaite. Ainsi pour assurer un contact correct entre le circuit imprimé 100 et les bornes des afficheurs à cristaux liquides, il est préférable de prévoir entre ces deux éléments un organe de contact intermédiaire assurant des liaisons électriques élastiques entre le circuit imprimé 100 et l'afficheur à cristaux liquides.

A cette fin on pourra utiliser, de façon classique en soi, des interconnecteurs spécialement adaptés pour assurer une connexion entre des contacts d'un affichage à cristaux liquides et un circuit imprimé, qui sont formés d'un empilement d'éléments flexibles de contact stratifiés en caoutchouc silicone, alternativement conducteur et non conducteur. De tels dispositifs sont disponibles dans le commerce.

On va maintenant décrire le mode d'assemblage d'un afficheur à cristaux liquides et d'un circuit imprimé à l'aide d'un support conforme à la présente invention.

Dans un premier temps il convient d'introduire un afficheur à cristaux liquides à l'intérieur du périmètre défini par les deux parois longitudinales 11 et 12 et les deux cloisons-renfort intermédiaires 16, puis d'encliqueter les languettes 20 portant les reliefs 21 dans un circuit imprimé 100 muni des pistes conductrices 102 et des plots correspondants 101, et dans lequel sont ménagés en outre des trous 103, 104 et 105 appropriés. Par déformation élastique, lesdites languettes 20 pénètrent dans les trous 103 et 104. Pour ce faire il est bien entendu nécessaire de déformer légèrement les lamelles 41 à 44. Lorsque les reliefs 21 des languettes ont ainsi traversé la plaque de circuit imprimé 100, les languettes reviennent à leur position initiale, et l'ensemble est ainsi verrouillé. Bien entendu, si cela est nécessaire, il est possible d'introduire un organe de contact intermédiaire entre le circuit imprimé et les afficheurs, comme cela a été précédemment indiqué. La déformation des lamelles 41 à 44 permet d'absorber les fluctuations des côtes d'épaisseur du verre des afficheurs, de la planéité du circuit imprimé et éventuellement de la compression de l'organe intermédiaire.

La Demanderesse a ainsi constaté que grâce à la rigidité propre des plaques de verre des afficheurs à cristaux liquides, les quatre points de contact élastiques définis sur l'afficheur (à raison de deux points de contact à chaque extrémité) par les saillies formées par l'extrémité des lamelles 41 à 44 maintiennent correctement le circuit imprimé contre les portées d'appui, permettent d'immobiliser correctement l'afficheur à cristaux liquides, et d'assurer une interconnexion électrique correcte.

On va maintenant donner à titre d'exemple non limitatif les principales dimensions d'un dispositif support conforme à la présente invention destiné à supporter des afficheurs à cristaux liquides comportant six caractères, ledit support étant réalisé en une pièce en matériau polymère moulé :

     - longueur des parois longitudinales 11 et 12 : 87 mm,

     - longueur des parois transversales 13 et 14 : 35 mm,

     - hauteur des languettes 20 : 10 mm,

     - largeur moyenne des languettes 20 : 5 mm,

     - épaisseur des languettes 20 : 1 mm,

     - longueur des lamelles 41 à 44 : 8 mm,

     - largeur moyenne des lamelles 41 à 44 : 2,5 mm,

     - épaisseur des lamelles 41 à 44 : 1,5 mm.

Bien entendu, la présente invention n'est pas limitée au mode de réalisation qui vient d'être décrit à partir duquel on pourra imaginer de nombreuses variantes de réalisation sans pour autant sortir du cadre de la présente invention.

Ainsi, il est possible de prévoir des lamelles élastiques ayant des formes les plus diverses. Accessoirement il est également possible de réaliser lesdites lamelles sous forme d'une structure élastique séparée insérée dans le support, entre celui-ci et l'afficheur.

De même la Demanderesse a constaté qu'il n'était pas indispensable que le dispositif support pour afficheurs à cristaux liquides soit formé d'un cadre rigide, la rigidité propre des plaques de verre des afficheurs à cristaux liquides étant parfaitement suffisante en elle-même pour assurer la tenue de l'ensemble, dans la mesure où des efforts appropriés sont appliqués à chaque extrémité de l'afficheur.

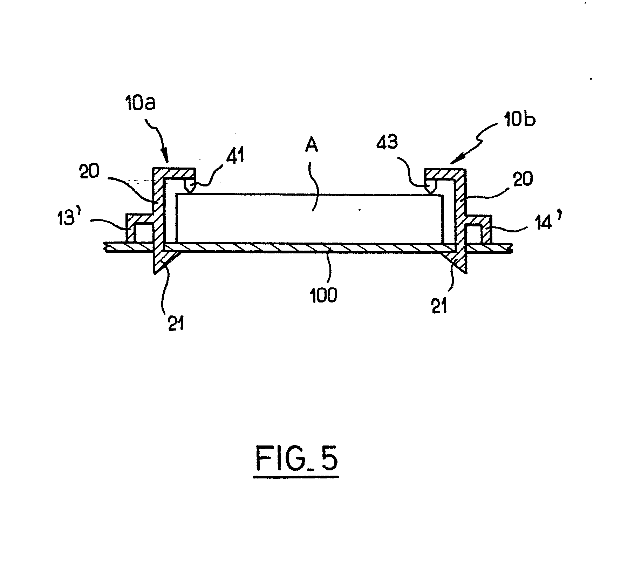

Ainsi, comme cela est représenté schématiquement sur la figure 5, on peut concevoir que le dispositif support d'afficheurs soit constitué de deux pièces séparées 10a et 10b, disposées respectivement à chacune des extrémités de l'afficheur schématiquement représenté et référencé A.

Chacune desdites. pièces 10a et 10b possède une languette 20 munie à son extrémité libre d'un relief 21 formant portée d'appui et de deux lamelles (41 et 43) dont les extrémités libres, destinées à constituer des points de contact élastique sur l'afficheur A, forment saillie en direction des portées d'appui prévues sur lesdites languettes 20.

De préférence il est prévu des moyens arc-boutants 13' et 14' à l'opposé des lamelles par rapport aux languettes 20, obviant à la poussée de l'afficheur A sur lesdites lamelles.

Dans un tel cas, les arcs-boutants 13' et 14' étant comparables structurellement aux cloisons transversales 13 et 14 représentées sur les figures 1 à 3, le dispositif représenté sur la figure 5, qui est constitué de deux pièces séparées est comparable au dispositif décrit en regard des figures 1 à 3 pour lequel on aurait éliminer la portion médiane des parois longitudinales 11 et 12.

Bien entendu dans le cas où la rigidité et la tenue de la pince formée par les languettes 20, les reliefs 21 prévus sur celles-ci et les lamelles (41, 43) sont suffisantes, les arcs boutants 13' et 14' peuvent être supprimés.

De même on peut prévoir que les reliefs 21 sont prévus de part et d'autre des languettes 20 et non plus d'un seul côté de celles-ci, pour parfaire la stabilité de l'ensemble.

Le mode d'assemblage d'un tel dispositif est en tout point identique à celui qui a été précédemment décrit, l'afficheur A étant immobilisé entre un circuit imprimé 100 (accessoirement un organe de contact intermédiaire) et les lamelles (41, 43) lorsque les refliefs 21 des languettes ont franchi les orifices correspondants prévus dans ledit circuit imprimé.

REVENDICATIONS

1. Dispositif support pour afficheurs à cristaux liquides, caractérisé par le fait qu'il se compose d'un ensemble définissant au moins deux languettes parallèles (20) légèrement flexibles, qui sont munies au voisinage de l'une de leurs extrémités de reliefs (21) qui constituent des portées d'appui dirigées vers l'autre extrémité, lesdits reliefs (21) étant destinés à être encliqueter dans des orifices correspondants prévus dans la plaque de circuit imprimé (100) ou organe analogue pour venir en appui sur celui-ci, et par le fait qu'il est prévu, au voisinage de l'autre extrémité des languettes, des lamelles flexibles (41-44) dont les extrémités libres, destinées à constituer des points de contact élastique sur un afficheur posé sur le circuit imprimé, forment saillie en direction des portées d'appui prévues sur lesdites languettes, de telle sorte qu'un afficheur puisse être immobilisé entre le circuit imprimé et lesdites lamelles.

2. Dispositif support pour afficheurs à cristaux liquides selon la revendication 1, caractérisé par le fait qu'il comprend un cadre rigide rectangulaire (10) composé d'un assemblage de deux parois longitudinales (11, 12) et deux parois transversales (13, 14), par le fait que le cadre supporte à ses extrémités au moins deux languettes parallèles (20) légèrement flexibles, qui s'étendent perpendiculairement au plan moyen du cadre, et d'un même côté de celui-ci, lesdites languettes étant munies au voisinage de leur extrémité libre, de reliefs (21) qui constituent des portées d'appui dirigées vers le cadre, et étant destinées à venir s'encliqueter dans des orifices correspondants prévus dans une plaque de circuit imprimé (100) ou organe analogue, et par le fait qu'il est prévu des lamelles flexibles (41-44) à chaque extrémité du cadre et dans le contour de celui-ci, les extrémités libres des lamelles destinées à constituer des points de contact élastique sur l'afficheur, formant saillie en direction des portées d'appui prévues sur lesdites languettes.

**0089439**

3. Dispositif support pour afficheurs à cristaux liquides selon l'une des revendications 1 et 2, caractérisé par le fait qu'il est prévu quatre lamelles d'extension sensiblement parallèles au plan moyen du cadre, et disposées respectivement deux à deux à chaque extrémité du cadre.

4. Dispositif support pour afficheurs à cristaux liquides selon l'une des revendications 2 et 3, caractérisé par le fait que le cadre rigide supporte en outre un ergot de positionnement (30) normal au plan moyen du cadre (10) et disposé du même côté de celui-ci que lesdites languettes (20).

5. Dispositif support pour afficheurs à cristaux liquides selon l'une des revendications 3 et 4, caractérisé par le fait que les lamelles flexibles (41 à 44) sont reliées au cadre (10) au voisinage des parois transversales (13, 14) à mi-longueur de celles-ci, et s'étendent sensiblement latéralement en direction des parois longitudinales (11, 12), tout en étant légèrement inclinées en direction des portées d'appui définies sur les languettes (20).

6. Dispositif support pour afficheurs à cristaux liquides selon la revendication 1, caractérisé par le fait que ledit ensemble se compose de deux pièces séparées, disposées respectivement à chacune des extrémités de l'afficheur, chacune desdites pièces comportant d'une part au moins une languette (20), d'autre part au moins une lamelle (41).

7. Dispositif support pour afficheurs à cristaux liquides selon l'une des revendications 1 à 5, caractérisé par le fait qu'il est réalisé par moulage en une seule pièce d'un matériau polymère.

8. Dispositif support pour afficheurs à cristaux liquides selon la revendication 6, caractérisé par le fait qu'il est réalisé par moulage en deux pièces d'un matériau polymère.

0089439

FIG_1

FIG_2

FIG_3

FIG_4

0089439

## FIG. 5